# EUROPÄISCHE PATENTSCHRIFT

(11) **EP 1 575 101 B1**
(45) Veröffentlichungstag und Bekanntmachung des Hinweises auf die Patenterteilung: **02.02.2011**
(21) Anmeldenummer: 04090103.5
(22) Anmeldetag: 11.03.2004
(51) Int. Cl.: H01L 51/50

(54) **OLED-Bauelement und Display auf Basis von OLED-Bauelementen mit höherer Lebensdauer**
OLED element and display based on OLED elements with a higher lifetime
Dispositif OLED et panneau d'affichage basé sur des OLED à durée de vie plus grande

(43) Veröffentlichungstag der Anmeldung: 14.09.2005
(73) Patentinhaber: Samsung Mobile Display Co., Ltd., Suwon-si Gyeonggi-do (KR)
(72) Erfinder: Uhlig, Albrecht, 12524 Berlin (DE); Nolte, Kerstin, 10781 Berlin (DE); Schrader, Thomas, 12557 Berlin (DE)
(74) Vertreter: Hengelhaupt, Jürgen

(56) Entgegenhaltungen:
- WO-A-00/48257
- WO-A-02/093662
- WO-A-03/047317
- PATENT ABSTRACTS OF JAPAN Bd. 1998, Nr. 02, 30. Januar 1998 (1998-01-30) -& JP 09 270295 A (MATSUSHITA ELECTRIC IND CO LTD), 14. Oktober 1997 (1997-10-14)

## Beschreibung

Die Erfindung betrifft ein OLED-Bauelement und ein Display auf Basis von OLED-Bauelementen gemäß den Oberbegriffen der Ansprüche 1 und 17.

Das Grundprinzip, welches den OLED Bauelementen (organic light emitting device) zugrunde liegt, ist die Elektrolumineszenz. Hier werden durch geeignete Kontakte Elektronen und Defektelektronen (Löcher) in ein halbleitendes Material injiziert. Bei der Rekombination treffen ein Elektron und ein Defektelektron aufeinander und es entsteht ein elektrisch neutrales, aber angeregtes Molekül, welches, z.B. aus der Materialklasse der Polyfluorene stammend, unter Lichtaussendung in seinen Grundzustand zurückkehrt. Als organische Emittermaterialien sind verschiedene, organische Verbindungen bekannt, welche sich in niedermolekulare (SM-OLED) und polymere organische Verbindungen (pLED) unterteilen lassen.

Ein OLED Bauelement muss für einen effizienten Betrieb verschiedene Eigenschaften, wie z. B. Elektronen-, Lochleitung und Lichtemission, aufweisen. Dabei wird die Effizienz durch das Verhältnis von ausgesendetem Licht pro injiziertem Ladungsträger definiert. Die meisten der verwendeten Materialien erfüllen nur eine der vorgenannten Eigenschaften (Elektronen-, Lochleitung, Lichtemission) in befriedigendem Maße. Zur Verbesserung der Effizienz ist es daher bekannt, Vielschichtbauelemente zu verwenden, in denen unterschiedliche Schichten kombiniert werden.

So ist die Verwendung von Poly(etylendioxy-thiophen)-Polystyrol-Sulfonsäure (PDOT:PSS) oder Polyanilin (PANI) als Lochtransportmaterial oder Lochtransportschicht (HTL) sowohl für polymere (pLED) als auch für niedermolekulare (SM-OLED) Verbindungen, beispielsweise in Heitecker et al., Applied Physics Letters Vol. 82 Nr. 23 (2003-06-09) pp 4178 beschrieben. Die Funktion der Lochtransportschicht besteht in einer leichten Injektion von positiven Ladungen (Löcher) als auch in einer Glättung der Anode, welche regelmäßig aus Indium-Zinnoxid (ITO) besteht und auf welche die Lochtransportschicht mittels spin coating, Tintenstrahldrucken oder anderen Techniken aufgebracht wird. Durch die Verwendung von Lochtransportschichten kann die Bauelementeeffizienz, d.h das Verhältnis von ausgesendetem Licht pro injiziertem Ladungsträger, deutlich gesteigert werden, wodurch ein OLED-Bauelement bzw. ein OLED-Display einen geringeren Stromverbrauch aufweist.

Zwar erhöht die Verwendung einer Lochtransportschicht die Bauelementeeffizienz, jedoch wirkt sich das Vorhandensein einer Lochtransportschicht nachteilig auf die Lebensdauer eines OLED-Bauelements aus. So ist es beispielsweise aus Lin Ke et al. (Mat. Res. Symp. Proc. Vol 710 (2002) pp 239) bekannt, dass Indium(III) als Verunreinigung im (polymeren) lichtemittierenden Material (pLEP) eine Verstärkung der nicht strahlenden Rekombination der Elektronen-Lochpaare gegenüber der erwünschten strahlenden Rekombination (Elektrolumineszenz) verursacht. Das Anodenmaterial ITO wird als Quelle dieser Verunreinigung beschrieben. Dabei führt das Vorhandensein einer chemisch sauren Lochtransportschicht zu einer chemischen Reaktion zwischen Lochtransportschicht und Anode (ITO), wodurch Indium(III) freigesetzt wird und unerwünschterweise in das organische Emittermaterial diffundiert und/oder migriert.

Aus Chua et al. ist eine Bauelementestruktur wie ITO/Parylen/PDOT:PSS/Ph-PPV/Parylen/Ca/Al bekannt. Dabei ist zwischen der Anode (ITO) und der Lochtransportschicht (PDOT:PSS) eine Parylenschicht angeordnet. Die Funktion des Parylens besteht in einer Glättung der Anode als auch der lichtemittierenden Schicht (Ph-PPV), wodurch die Bildung so genannter "hot spots", d.h. Bereiche mit erhöhtem Stromtransport verringert werden soll.

Weiterhin ist die Verwendung einer Siliziumkarbidschicht zwischen Anode (ITO) und Lochtransportschicht eines OLED-Bauelementes, die Anordnung einer Siliziumoxidschicht (zwischen Anode und Lochtransportschicht) und die Anordnung einer Tantaloxidschicht (zwischen Anode und Lochtransportschicht) bekannt.

US 2003/0025445 A1 (Samsung SDI) beschreibt den Einsatz einer metallorganischen Verbindung der allgemeinen Formel R₁R₂MR₃R₄, wobei M für Si, Sn, Al, Ti, Pt, Sc, Y, Sr steht und R₁₋₄ silizium-organische Verbindungen sind. Diese metallorganische Verbindung wird zwischen der ITO Anode und der organischen Lochtransportschicht Schicht (HTL) oder zwischen der HTL Schicht und der Licht emittierenden Schicht aufgebracht. Diese Zwischenschicht weist jedoch keine ausreichende Dichtheit zur effizienten Verhinderung des Säureangriffs der Lochtransportschicht auf die Anodenschicht (ITO) sowie keine ausreichende mechanische Stabilität auf, weshalb eine Erhöhung der Lebensdauer eines OLED-Bauelementes mit Lochtransportschicht nicht realisierbar ist.

WO 02/093662 A2 (Opsys Ltd.) beschreibt die Verwendung einer dünnen Organosilanschicht für OLED, um eine dielektrische Zwischenschicht auf dem ITO zu erzeugen. Dazu wird die ITO Oberfläche zuerst mit einem flüssigen oder dampfförmigen Organosilan-Haftvermittler in Kontakt gebracht. Anschließend wird das derart behandelte Substrat einer oxidierenden Behandlung wie z.B. einer Sauerstoffplasma Behandlung oder eine Sauerstoffradikale enthaltende Gasentladung unterzogen. Durch diese Behandlung wird ein Dielektrikum in Form einer dünnen homogenen Schicht erzeugt. Dieses Dielektrikum verbessert nun die Ladungsinjektion vom ITO in die OLED, was zu einer Verbesserung der Bauelementeeffizienz führt. Eine Verlängerung der Lebensdauer des OLED-Bauelements, insbesondere eine Verhinderung des Säureangriffs der Lochtransportschicht auf die Anodenschicht (ITO) ist jedoch nicht möglich.

WO 03/047317 offenbart ein OLED-Bauelement mit einer Polymerschicht aus Teflon, Polytetrafluorethylen zwischen der Anodenschicht und der Lochtransfertschicht.

JP 0 92 70 295 offenbart ein OLED-Bauelement mit einer fluorierten Siloxanschicht auf der Kathode des Bauelements.

Nachteilig an allen vorgenannten OLED-Bauelementen, welche zur Steigerung der Effizienz eine Lochtransportschicht vorsehen, ist deren relativ geringe Lebensdauer.

Es ist daher Aufgabe der vorliegenden Erfindung, ein OLED-Bauelement sowie ein Display auf Basis von OLED-Bauelementen anzugeben, welche trotz Verwendung einer Lochtransportschicht zur Steigerung der Effizienz eine höhere Lebensdauer als die Bauelemente nach dem Stand der Technik aufweisen. Weiterhin sollen die optischen Eigenschaften des OLED-Bauelementes nicht beeinträchtigt werden.

Diese Aufgabe wird erfindungsgemäß gelöst durch die Merkmale im kennzeichnenden Teil des Anspruchs 1 (OLED-Bauelement) und die Merkmale im kennzeichnenden Teil des Anspruchs 17 (Display) im Zusammenwirken mit den Merkmalen im Oberbegriff. Zweckmäßige Ausgestaltungen der Erfindung sind in den Unteransprüchen enthalten.

Dadurch, dass zwischen Anode und Lochtransportschicht oder zwischen Anode und Lochinjektionsschicht eines OLED-Bauelementes eine kontinuierliche Anodenschutzschicht aus fluoriertem Polysiloxan und/oder als Beispiel, nicht Teil der Erfindung, fluoriertem Kohlenwasserstoff angeordnet wird, kann die Lebensdauer eines OLED-Bauelementes überraschenderweise deutlich erhöht werden. Die erfindungsgemäße Anodenschutzschicht verhindert einerseits den Säureangriff der Lochtransportschicht auf das Anodenmaterial, welcher insbesondere durch die Reaktion der in der Lochtransportschicht befindlichen freien Protonen mit dem Anodenmaterial entstehen. Ein hundertprozentiger Schutz ist jedoch kaum realisierbar, da die erfindungsgemäße Anodenschutzschicht keinesfalls die optischen und elektrischen Eigenschaften des OLED-Bauelementes negativ beeinflussen darf. Deshalb verhindert die erfindungsgemäße Anodenschutzschicht andererseits die Abdiffusion bzw. Migration der durch die Reaktion der freien Protonen der Lochtransportschicht mit dem Anodenmaterial entstehenden Metallkationen, wie beispielsweise Indium(III) zur Emitterschicht.
Vorteilhafterweise weisen sowohl fluorierte Kohlenwasserstoffe als auch fluoriertes Polysiloxan ein hydrophobes Verhalten auf. Hierdurch wird insbesondere der Transport freier Protonen (aus der Lochtransportschicht) zum Anodenmaterial (ITO) deutlich unterdrückt. Ein weiterer Vorteil besteht darin, dass die hydrophobe Wirkung der vorgenannten Materialien bereits durch sehr dünne Schichten erzielbar ist, welche keinen negativen Einfluss auf die optischen und elektrischen Eigenschaften eines OLED-Bauelementes besitzen.

Das Polysilixan bzw. die Polysiloxanschicht ist vorzugsweise kovalent vernetzt. Hierdurch wird vorteilhafterweise eine starke Haftung der Polysiloxanschicht zur Anode erzielt. Ein weiterer Vorteil besteht darin, dass aufgrund der Quervernetzung eine kompakte Diffusionsbarriere sowohl für Protonen als auch für Metallkationen realisiert werden kann, wodurch der Säureangriff der HTL auf die Anode als auch die Diffusion/Migration von Metallkationen ins lichtemittierende Material verringert werden kann.

In einer bevorzugten Ausführungsvariante ist der fluorierte Kohlenwasserstoff Polytetrafluorethylen und das Polysiloxan ist aus Heptadecafluoro-1,1,2,2-tetrahydrodecyldimethylchloro-silan hergestellt. In einer besonders bevorzugten Ausführungsvariante besteht die Anodenschutzschicht aus mehreren kontinuierlichen, übereinander angeordneten Schichten aus Polysiloxan. Die verwendeten Materialien für die Anodenschutzschicht bilden auf der Anodenschicht eine kontinuierliche, geschlossene Schicht. Eine solche Schicht kann für Polytetrafluorethylen durch Abscheiden aus der Gasphase mittels CVD (chemical vapour deposition) oder durch thermisches Verdampfen erzielt werden. Für Polysiloxane kann eine solche Schicht durch chemische Reaktion der Siloxane mit der Anodenoberfläche als auch der Siloxane untereinander (Polymerisation) realisiert werden. Eine starke Haftung der Siloxane zur Anodenschicht wird durch eine kovalente Bindung der Siloxane untereinander erzielt und stellt somit eine kompakte Diffusionsbarriere für die Metallkationen dar. Weiterhin ist die Verwendung von Siloxanen zur Herstellung einer Anodenschutzschicht vorteilhaft, da eine solche Schicht nasschemisch aufgetragen wird und daher kostengünstig ist. Die Anodenschutzschicht weist vorzugsweise eine Dicke zwischen 0,1 nm und 50 nm auf. Die Lochtransportschicht ist vorzugsweise aus Polyanilin oder aus Poly(Ethylendioxythiophen)-Polystyrolsulfonsäure (PDOT:PSS) gebildet. Die Anodenschicht besteht vorzugsweise aus Indium-Zinn-Oxid.

Durch die Verminderung der Bildung von Metallkationen durch den Säureangriff der Lochtransportschicht auf die Anodenschicht sowie durch die Verhinderung der Abdiffusion der möglicherweise entstandenen Metallkationen zum polymeren Emittermaterial wie beispielsweise aus den Materialklassen der Poly(phenylenvinylene) oder der Polyfluorene, kann die Lebensdauer dieser polymeren organischen Emittermaterialien im Vergleich zu Bauelementen ohne erfindungsgemäße Anodenschutzschicht deutlich, d.h. um zirka 30 % erhöht werden. Vorteilhafterweise lässt sich der Schritt des Herstellens einer Anodenschutzschicht leicht in die OLED-Herstellungstechnologie einfügen, da diese Schicht durch nasschemisches Auftragen für die Polysiloxanschicht oder eine einfache Gasphasenabscheidung für die Teflonschicht (Polytetrafluorethylen) einen technologischen einfachen Prozess darstellt. Die erfindungsgemäße Anodenschutzschicht aus Polytetrafluorethylen oder fluoriertem Polysiloxan zeichnet sich gegenüber bekannten, zwischen Lochtransportschicht und Anode angeordneten Schichten dadurch aus, dass sie aufgrund der kovalenten Vernetzung der Siloxane bzw. des Tetrafluorethylens eine stärkere Diffusionsbarriere sowohl gegen Protonen als auch gegen Metallkationen darstellt und somit den Säureangriff der Lochtransportschicht auf die Anodenschicht als auch ein Abdiffundieren entstandener Metallkationen effizienter verhindert.
Ein weiterer erfindungsgemäßer Vorteil der Anodenschutzschicht besteht in ihrer wasserabweisenden Funktion bei sehr geringer Schichtdicke, wodurch der Einfluss auf andere Bauelementeeigenschaften wie elektrische Effizienz oder Farbsättigung der Elektrolumineszenz gering gehalten werden kann.

Die Erfindung wird nachstehend anhand von Ausführungsbeispielen näher erläutert.
Es zeigen:
- Figur 1: ein erfindungsgemäßes OLED-Bauelement in schematischer, geschnittener Darstellung,
- Figur 2: ein Reaktionsschema zur Bildung einer auf Polysiloxan basierenden Anodenschutzschicht,
- Figur 3: das Schema einer mehrlagigen durch Polysiloxane gebildeten Anodenschutzschicht.

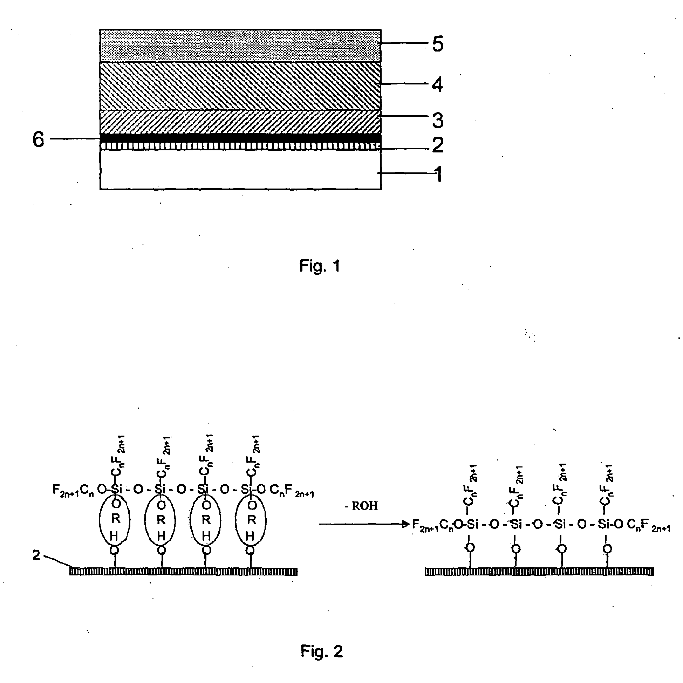

Figur 1 zeigt ein erfindungsgemäßes OLED-Bauelement in schematischer, geschnittener Darstellung. Auf einem Glassubstrat 1 ist eine Anode 2 angeordnet. Auf der Anode 2 ist die erfindungsgemäße Anodenschutzschicht 6 aus fluoriertem Polysiloxan angeordnet. Über der Anodenschutzschicht 6 ist eine Lochtransportschicht 3 angeordnet. Darauf ist ein lichtemittierendes Polymer 4 angeordnet, auf welchem eine Mehrschichtkathode 5 angeordnet ist.
Die Herstellung eines erfindungsgemäßen OLED-Bauelementes gemäß Figur 1 wird nachfolgend anhand eines Ausführungsbeispieles näher beschrieben.

Als Grundsubstrat 1 wird ein Bor-Silikat-Glas verwendet, welches mit einer 180 nm Anodenschicht 2 aus Indium-Zinnoxid (ITO) beschichtet ist. Zur Ausbildung eines OLED-Bauelementes mit einer lichtemittierenden Fläche von 2 mm² wird die Anode 2 derart strukturiert, dass sich in der Mitte des Substrates 1 ein 2 mm breiter ITO-Streifen befindet. Das Substrat 1 wird durch ein 5-minütiges Ultraschallbad in Isopropanol, anschließendes Trocknen im Stickstofffluss sowie eine 10-minütige Behandlung mit UV/Ozon gereinigt.

In einem nächsten Schritt wird eine Polysiloxanschicht (Anodenschutzschicht 6) aufgebracht. Dazu wird eine 10 %ige (nach Gewicht) Lösung aus Heptadecafluoro-1,1,2,2-tetrahydrodecyl-dimethylchloro-silan (Gelest, Inc) in 96 % Ethanol (Carl Roth GmbH) durch fünfminütiges Rühren hergestellt. Das Substrat 1 mit der darauf befindlichen Anode 2 wird nun in diese Lösung getaucht und dort für 5 Minuten unter Rühren behalten. Nach Trocknen an der Luft wird das derart behandelte Substrat (Substrat 1 mit Anode 2 und Anodenschutzschicht 6) 30 Minuten bei 160 °C auf einer Heizplatte getrocknet.

Alternativ, nicht Teil der Erfindung, zum Aufbringen einer Polysiloxanschicht kann als Anodenschutzschicht 6 auch eine Schicht aus Polytetrafluorethylen abgeschieden werden. Dazu wird das Substrat (Substrat 1 mit der darauf befindlichen Anode 2) in eine Mikrowellenplasmaanlage gebracht. Durch Einspeisung von C₃F₈-Gas bei einer Flussrate von 200 ml/min und einem Kammerdruck von 200 Pa wird Polytetrafluorethylen bei einer Plasmaleistung von 200 W erzeugt. Die Abscheidung des Polytetrafluorethylens auf dem Substrat erfolgt durch Verwendung einer Schattenmaske nur in der Mitte des Substrates auf einer Fläche von 2 mm². Nach 4 Sekunden wird auf diese Art eine 2 nm Anodenschutzschicht 6 aus Polytetrafluorethylen abgeschieden. Alternativ zu C₃F₈-Gas können auch andere fluorhaltige Gase wie beispielsweise C₃F₆ auch C₂F₄ verwendet werden.

In einem nächsten Schritt wird LVW 142 (Baytron P® der Bayer AG) als 50 nm dicke Lochtransportschicht 3 durch spin coating aufgetragen und anschließend für 10 Minuten bei 200 °C in einer Stickstoffatmosphäre getrocknet.

In einem nächsten Schritt wird das Licht emittierende Polymer 4 (SCB 11, DOW LUMINATION® von Dow Chemical) aus einer 1-%-Lösung (nach Gewicht) in wasserfreiem Xylol als 70 nm dicker Film durch spin coating in einer Stickstoffatmosphäre aufgebracht und anschließend in der gleichen Atmosphäre für 10 Minuten bei 110 °C auf einer Heizplatte getrocknet.

In einem nächsten Schritt wird das Substrat (Substrat 1, Anode 2, Anodenschutzschicht 6, Lochtransportschicht 6, Licht emittierendes Polymer 4) in einer Stickstoffatmosphäre in eine Vakuumanlage transferiert. Hier wird durch thermisches Verdampfen nacheinander von 1 nm Lithiumfluorid, 10 nm Kalzium und 500 nm Aluminium die Kathode 5 derart aufgedampft, dass in der Mitte des Substrates eine 2 mm² große Überlappung mit der Anode 2 sowie eine zum externen elektrischen Kontaktieren geeignete Fläche gebildet wird.

Nach Transfer des Substrates unter Schutzgas wird das Substrat mittels einer Glasscheibe und eines Epoxyklebers derart verkapselt, dass ein Zutritt von Sauerstoff und Wasser aus der Umgebung zur OLED stark eingeschränkt wird. Die Funktion des OLED-Bauelementes kann nachfolgend durch Anlegen einer Spannung im Bereich von 3 bis 4 V zwischen Anode 2 und Kathode 5 überprüft werden.

Die erfindungsgemäße Anodenschutzschicht 6 verringert den Angriff der sauren Lochtransportschicht 3 auf die Anodenschicht 2, welche regelmäßig durch Indium-Zinn-Oxid ausgebildet ist. Dies wird insbesondere dadurch realisiert, dass die aus Polysiloxan oder fluoriertem Kohlenwasserstoff, nicht Teil der Erfindung, bestehende Anodenschutzschicht 6 als Diffusionsbarriere für Protonen wirkt. Zusätzlich wirkt die Anodenschutzschicht 6 ebenfalls als Diffusionsbarriere für Metallkationen, wie beispielsweise Indium (III), und verhindert so eine Abdiffusion bzw. Migration der an der Anodenschicht 2 entstandenen Metallkationen ins polymere Emittermaterial 4, in welchem die Metallkationen eine Schädigung der Emitterpolymere 4 hervorrufen und somit die Lebensdauer des OLED-Bauelementes verringern können.

In Figur 2 ist das Reaktionsschema der Kondensation von Polysiloxan und der Anode 2 zu einer auf Polysiloxan basierenden Anodenschutzschicht schematisch dargestellt. Insbesondere die Verwendung fluorierter Alkylseitenketten beim Polysiloxan führt zu einer wasserabweisenden Funktion bei einer geringen Schichtdicke, wodurch die Ausbildung einer dünnen, effektiven Anodenschutzschicht 6, welche keinen negativen Einfluss auf die elektrischen oder optischen Eigenschaften des OlED-Bauelementes besitzt, möglich wird. Nach der Figur 2 schematisch dargestellten Reaktion des Polysiloxans mit der Anodenschicht 2 weisen die Siloxane untereinander kovalente Bindungen auf, wodurch eine kompakte Diffusionsbarriere sowohl für Protonen als auch Metallkationen ausgebildet werden kann.

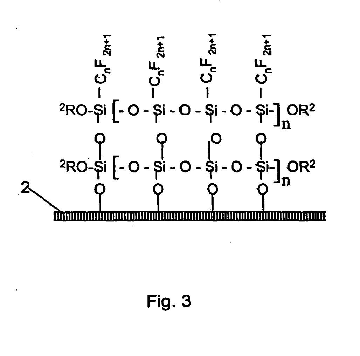

Figur 3 zeigt das Schema einer mehrlagigen Anodenschutzschicht 6, welche auf einer Anodenschicht 2 angeordnet ist. Durch die Ausbildung mehrerer Schichten von Polysiloxan kann die Wirkung als Diffusionsbarriere für Protonen und Metallkationen weiter erhöht werden.

### Bezugszeichenliste

- 1: Substrat
- 2: Anode/Indium-Zinn-Oxid
- 3: Lochtransportschicht
- 4: Licht emittierendes Polymer
- 5: Mehrschichtkathode
- 6: Anodenschutzschicht

## Patentansprüche

1. OLED-Bauelement aufweisen ein Substrat (1), eine Anode (2), eine Lochinjektionsschicht und/oder eine Lochtransportschicht (3), organisches Emittermaterial (4) und eine Kathode (5), **dadurch gekennzeichnet, dass** zwischen Anode (2) und Lochtransportschicht (3) oder zwischen Anode (2) und Lochinjektionsschicht eine kontinuierliche Anodenschutzschicht (6) aus fluoriertem Polysiloxan angeordnet ist.

2. Bauelement nach Anspruch 1, **dadurch gekennzeichnet, dass** das Polysiloxan kovalent vernetzt ist.

3. Bauelement nach Anspruch 1 oder 2, **dadurch gekennzeichnet, dass** das Polysiloxan aus Heptadecafluoro-1,1,2,2-tetrahydrodecyl-dimethylchloro-silan hergestellt ist.

4. Bauelement nach einem der vorhergehenden Ansprüche, **dadurch gekennzeichnet, dass** die Anodenschutzschicht (6) aus mehreren kontinuierlichen, übereinander angeordneten Schichten aus Polysiloxan besteht.

5. Bauelement nach einem der vorhergehenden Ansprüche, **dadurch gekennzeichnet, dass** die Anodenschutzschicht (6) eine Schichtdicke von 0.1 nm bis 50 nm aufweiset.

6. Bauelement nach einem der vorhergehenden Ansprüche, **dadurch gekennzeichnet, dass** die Lochtransportschicht (3) aus Polyanilin (PANI) oder aus Poly(Ethylendicixythiophen)-Polystyrolsulfonsäure (PDOT:PSS) besteht.

7. Bauelement nach einem der vorhergehenden Ansprüche, **dadurch gekennzeichnet, dass** die Anode (2) aus Indiumzinnoxid (ITO) besteht.

8. Bauelement nach einem der vorhergehenden Ansprüche, **dadurch gekennzeichnet, dass** das organische Emittermaterial (4) aus den Materialklassen der Poly(phenylenvinylen)e oder der Polyfluorene ausgewählt ist.

9. Bauelement nach einem der vorhergehenden Ansprüche, **dadurch gekennzeichnet, dass** die Lochtransportschicht (3) eine Dicke zwischen 30 nm und 150 nm aufweist.

10. Bauelement nach einem der vorhergehenden Ansprüche, **dadurch gekennzeichnet, dass** das organische Emittermaterial (4) eine Schichtdicke zwischen 50 nm und 120 nm aufweist.

11. Bauelement nach einem der vorhergehenden Ansprüche, **dadurch gekennzeichnet, dass** die Kathode (5) eine Mehrschichtkathode ist, welche Kalzium und Aluminium aufweist.

12. Bauelement nach einem der vorhergehenden Ansprüche, **dadurch gekennzeichnet, dass** die Kathode (5) aus 10 nm Ca/ 500 nm Al besteht.

13. Bauelement nach einem der vorhergehenden Ansprüche, **dadurch gekennzeichnet, dass** zwischen organischem Emittermaterial (4) und Kathode (5) eine Schicht eines Alkali- oder Erdalkalifluorids angeordnet ist.

14. Bauelement nach Anspruch 13, **dadurch gekennzeichnet, dass** die Schicht eines Alkali- oder Erdalkalifluorids zumindest teilweise die Kathode (6) ausbildet.

15. Bauelement nach Anspruch 13 oder 14, **dadurch gekennzeichnet, dass** das Alkalifluorid Lithiumfluorid ist.

16. Bauelement nach einem der vorhergehenden Ansprüche, **dadurch gekennzeichnet, dass** das Bauelement eine Verkapselung aufweist.

17. Display auf Basis organischer Leuchtdiode **gekennzeichnet durch** mindestens ein Bauelement nach einem der Ansprüche 1 bis 16.

## Claims

1. OLED structural element having a substrate (1), an anode (2), a hole injection layer and/or a hole transport layer (3), organic emitter material (4) and a cathode (5) **wherein,** between anode (2) and hole transport layer (3) or between anode (2) and hole injection layer, a continuous anode protective layer (6) consisting of fluorinated polysiloxane is arranged.

2. Structural element according to Claim 1, **wherein** the polysiloxane is interlaced in a covalent manner.

3. Structural element according to Claim 1 or Claim 2, **wherein** the polysiloxane is manufactured from heptadecafluoro-1, 1, 2, 2-tetrahydrodecyl-dimethyl-chloro silane.

4. Structural element according to one of the previous Claims, **wherein** the anode protective layer (6) consists of several continuous layers of polysiloxane arranged above one another.

5. Structural element according to one of the previous Claims, **wherein** the anode protective layer (6) has a layer thickness of 0.1 nm to 50 nm.

6. Structural element according to one of the previous Claims, **wherein** the hole transport layer (3) consists of polyaniline (PANI) or of poly (ethylene dioxy-thiophene) - polystyrene sulfone acid (PDOT:PSS).

7. Structural element according to one of the previous Claims, **wherein** the anode (2) consists of indium tin oxide (ITO).

8. Structural element according to one of the previous Claims, **wherein** the organic emitter material (4) is selected from the material classes of the poly (phenyl-envinylenes) or of the polyfluorenes.

9. Structural element according to one of the previous Claims, **wherein** the hole transport layer (3) has a thickness of between 30 nm and 150 nm.

10. Structural element according to one of the previous Claims, **wherein** the organic emitter material (4) has a layer thickness between 50 nm and 120 nm.

11. Structural element according to one of the previous Claims, **wherein** the cathode (5) is a multi-layer cathode having calcium and aluminium.

12. Structural element according to one of the previous Claims, **wherein** the cathode (5) consists of 10 nm Ca/ 500 nm Al.

13. Structural element according to one of the previous Claims, **wherein** a layer of an alkaline or alkaline earth fluoride is arranged between organic emitter material (4) and cathode (5).

14. Structural element according to Claim 13, **wherein** the layer of an alkaline or alkaline earth fluoride at least partially forms the cathode (6).

15. Structural element according to Claim 13 or Claim 14, **wherein** the alkaline fluoride is lithium fluoride.

16. Structural element according to one of the previous Claims, **wherein** the structural element has an encapsulation.

17. Display on the basis of organic light-emitting diodes, **characterised by** at least one structural element according to the Claims 1 to 16.

## Revendications

1. Dispositif OLED présentant un substrat (1), une anode (2), une couche d'injection de trous et/ou une couche de transport de trous (3), un matériau émetteur organique (4) et une cathode (5), **caractérisé en ce qu'**une couche continue de protection de l'anode (6) en polysiloxane fluoré est disposée entre l'anode (2) et la couche de transport de trous (3) ou entre l'anode (2) et la couche d'injection de trous.

2. Dispositif selon la revendication 1, **caractérisé en ce que** le polysiloxane est réticulé par des liaisons covalentes.

3. Dispositif selon la revendication 1 ou la revendication 2, **caractérisé en ce que** le polysiloxane est produit à partir d'heptadécafluoro-1,1,2,2-tétrahydrodécyl-diméthylchlorosilane.

4. Dispositif selon l'une des revendications précédentes, **caractérisé en ce que** la couche de protection de l'anode (6) se compose de plusieurs couches continues en polysiloxane disposées les unes par dessus les autres.

5. Dispositif selon l'une des revendications précédentes, **caractérisé en ce que** la couche de protection de l'anode (6) présente une épaisseur allant de 0,1 nm à 50 nm.

6. Dispositif selon l'une des revendications précédentes, **caractérisé en ce que** la couche de transport de trous (3) est constituée de polyaniline (PANI) ou de poly(éthylènedioxythiophène)-acide polystyrène sulfonique (PDOT:PSS).

7. Dispositif selon l'une des revendications précédentes, **caractérisé en ce que** l'anode (2) est constituée d'oxyde d'indium dopé à l'étain (ITO).

8. Dispositif selon l'une des revendications précédentes, **caractérisé en ce que** le matériau émetteur organique (4) est choisi dans les classes de matériaux poly(phénylènevinylènes) ou polyfluorènes.

9. Dispositif selon l'une des revendications précédentes, **caractérisé en ce que** la couche de transport de trous (3) présente une épaisseur allant de 30 nm à 150 nm.

10. Dispositif selon l'une des revendications précédentes, **caractérisé en ce que** le matériau émetteur organique (4) présente une épaisseur de couche allant de 50 nm à 120 nm.

11. Dispositif selon l'une des revendications précédentes, **caractérisé en ce que** la cathode (5) est une cathode multicouche contenant du calcium et de l'aluminium.

12. Dispositif selon l'une des revendications précédentes, **caractérisé en ce que** la cathode (5) est constituée de 10 nm de Ca et 500 nm d'Al.

13. Dispositif selon l'une des revendications précédentes, **caractérisé en ce qu'**une couche d'un fluorure de métal alcalin ou alcalino-terreux est disposée entre le matériau émetteur organique (4) et la cathode (5).

14. Dispositif selon la revendication 13, **caractérisé en ce que** la couche de fluorure de métal alcalin ou alcalino-terreux forme au moins en partie la cathode (6).

15. Dispositif selon la revendication 13 ou la revendication 14, **caractérisé en ce que** le fluorure de métal alcalin est le fluorure de lithium.

16. Dispositif selon l'une des revendications précédentes, **caractérisé en ce que** le dispositif présente une encapsulation.

17. Afficheur à base de diodes électroluminescentes organiques, **caractérisé en ce qu'**il comprend au moins un dispositif selon l'une des revendications 1 à 16.
